# EUROPÄISCHE PATENTSCHRIFT

(11) **EP 1 986 204 B1**
(45) Veröffentlichungstag und Bekanntmachung des Hinweises auf die Patenterteilung: **12.07.2017**
(21) Anmeldenummer: 08007406.5
(22) Anmeldetag: 16.04.2008
(51) Int. Cl.: H01H 9/02, H01H 1/58, H01H 11/00, H05K 3/30, H05K 13/08, H05K 13/04, H01C 1/01, H05K 1/02, G01R 31/28, H05K 3/22, H05K 3/20

(54) **Verfahren zur Herstellung eines elektromechanischen Schalters**
Method for manufacturing an electromechanical switch.
Procédé de fabrication d'un interrupteur électromécanique.

(30) Priorität: 16.04.2007 DE 102007018207; 17.04.2007 DE 102007018376
(43) Veröffentlichungstag der Anmeldung: 29.10.2008
(73) Patentinhaber: Marquardt GmbH, 78604 Rietheim-Weilheim (DE)
(72) Erfinder: Mattes, Christoph, 78589 Dürbheim (DE); Morariu, Constantin-Romeo, 78604 Rietheim-Weilheim (DE); Hasselbrinck, Ingo, 78549 Spaichingen (DE); Hengstler, Hans, 78554 Aldingen (DE); Behr, Volker, 78628 Rottweil (DE); Riesenberg, Jens, 42285 Wuppertal (DE)
(74) Vertreter: Otten, Roth, Dobler & Partner mbB Patentanwälte

(56) Entgegenhaltungen:
- EP-A1- 0 117 984
- EP-A2- 0 081 929
- DE-A1- 3 702 346
- DE-A1- 3 804 558
- DE-A1- 4 107 896
- GB-A- 2 069 777
- US-A- 4 168 404
- US-A- 4 463 310
- US-A- 4 557 043
- US-A- 4 874 907
- US-A- 4 947 112
- US-A1- 2003 136 656
- US-A1- 2004 190 273
- US-B1- 6 683 449
- ANONYMOUS: "Parts presence pogo pin" RESEARCH DISCLOSURE, MASON PUBLICATIONS, HAMPSHIRE, GB, Bd. 356, Nr. 40, 1. Dezember 1993 (1993-12-01), XP007119517 ISSN: 0374-4353

## Beschreibung

In den Druckschriften US 2003/136656 A1, US 4,168,404 A, DE 41 07 896 A1, DE 37 02 346 A1 sowie EP 0 117 984 A1 sind Schalter beschrieben, zwischen deren Kontakten zur Kontaktierung mit einer Platine elektrische Widerstände angeordnet sind.

EP 0 081 929 A2 offenbart ein Verfahren zur Herstellung eines elektromechanischen Schalters gemäß der Präambel von Anspruch 1. Die Erfindung betrifft ein Verfahren zur Herstellung eines elektromechanischen Schalters nach Patentanspruch 1.

Der Erfindung liegt die Aufgabe zugrunde, ein Verfahren zur Herstellung eines elektromechanischen Schalters mittels Stanzgitter vorzuschlagen.

Diese Aufgabe wird vom Verfahren gemäß des unabhängigen Anspruchs 1 gelöst. In den Unteransprüchen sind vorteilhafte und zweckmäßige Weiterbildungen angegeben.

Das erfindungsgemäße Verfahren zur Herstellung eines elektromechanischen Schalters, wobei der Schalter mindestens einen elektrischen Widerstand zwischen wenigstens zwei Kontaktstellen umfasst, nutzt die Anbringung des elektromechanischen Schalters und mindestens des einen anzubringenden Widerstands in jeweils einem Stanzgitter, wobei in einem ersten Verfahrensschritt die jeweiligen Stanzgitter derart in eine überdeckende Positionierung gebracht werden, dass eine verarbeitungsgemäße Positionierung des mindestens einen Widerstands im zur Anbringung vorgesehenen Bereich am Bauelement erfolgt. Durch eine derartige Positionierung wird erreicht, dass entweder einzelne Widerstände oder auch auf Trägern angebrachte Widerstandsanordnungen relativ zum Herstellungsrohling eines Bauelements wie beispielsweise eines elektromechanischen Schalters bereits in der verarbeitungsgemäßen Position vorliegen, so dass ein positionierender Bestückungsvorgang, wie beispielsweise ein Bestückungsroboter entbehrlich wird. Vorteilhaft am vorliegenden Verfahren ist, dass am Schalterrohling entsprechende Ausnehmungen vorgesehen sein können, welche in ihrer Position der angestrebten überdeckenden Positionierung der Widerstände entsprechen, so dass diese im Bereich der Ausnehmungen am Bauelement angebracht werden können. Im erfindungsgemäßen Verfahren werden die Stanzgitter vor dem Verarbeitungsschritt durch Positionierhilfen relativ zueinander positioniert und gegebenenfalls fixiert, sodann in einem Arbeitsschritt sowohl die Anbringung des mindestens einen Widerstands als auch die Abtrennung vom Stanzgitter des Widerstands vorgenommen. Vorzugsweise kann auch eine Vorpositionierung der im jeweiligen Stanzgitter gehaltenen Bestandteile in einem vorhergehenden Arbeitsschritt, insbesondere eine Vorpositionierung des mindestens einen Widerstands oder einer Widerstandsanordnung auf einem Träger, erfolgen.

weitere Einzelheiten der Erfindung werden in der Zeichnung anhand von schematisch dargestellten Ausführungsbeispielen beschrieben.

Hierbei zeigt:
- Figur 1: eine schematische Ansicht einer Vorrichtung zur Bestückung einer Platine, vor dem Bestücken der Platine mit dem Schalter;
- Figur 2: eine weitere Ansicht der aus der Figur 1 bekannter Vorrichtung, wobei der Schalter auf die Platine aufgesetzt ist und die Widerstandsmesseinrichtung misst;
- Figur 3: eine geschnittene Seitenansicht einer Ausführungsvariante eines elektromechanischen Schalters mit Widerständen und
- Figur: 4 eine perspektivische Ansicht eines unteren Teils des in der Figur 5 gezeigten elektromechanischen Schalters.
- Figur 5: zeigt einen Ausschnitt aus einem erfindungsgemäßen Stanzgitter mit Schalterrohlingen.
- Figur 6: zeigt einen Ausschnitt aus einem erfindungsgemäßen Stanzgitter mit Widerständen.
- Figur 7: zeigt einen erfindungsgemäßen Ausschnitt aus überkreuzt laufenden Stanzgittern im Vereinigungsbereich.

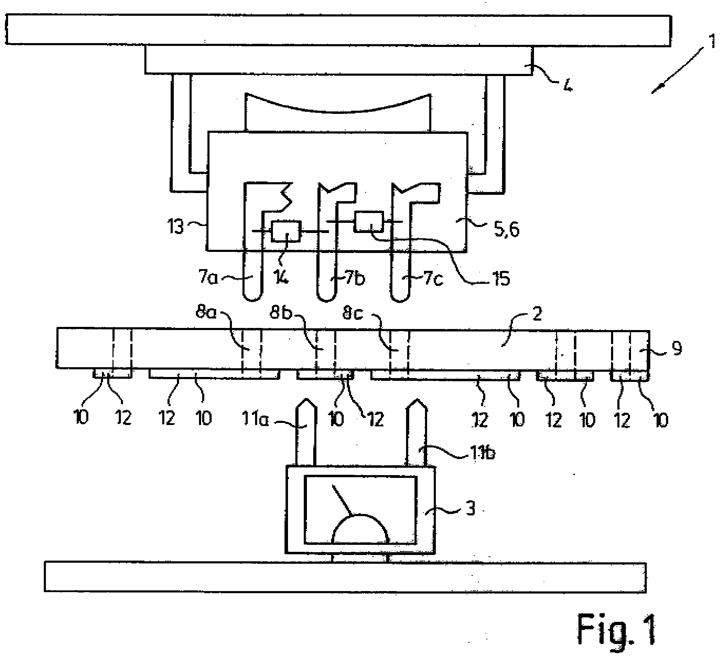

In der Figur 1 ist eine schematische Ansicht einer Vorrichtung 1 zur Bestückung einer Platine 2 mit einer Widerstandsmesseinrichtung 3 dargestellt. Die Vorrichtung 1 umfasst neben der Widerstandmesseinrichtung 3 einen verfahrbaren Greifer 4, welcher ein Bauelement 5 gegriffen hat. Das Bauelement 5 ist als elektromechanischer Schalter 6 ausgeführt und wird von dem Greifer 4 über der Platine 2 positioniert. Der elektromechanische Schalter 6 weist drei Kontakte 7a bis 7c auf, welche auf Bohrungen 8a bis 8c in der Platine 2 ausgerichtet sind. Die Kontakte 7a bis 7c sind als Kontaktstifte ausgeführt. Die Bohrungen 8a bis 8c durchlaufen eine Träger 9 und Leiterbahnen 10 der Platine 2. Die verfahrbare Widerstandsmesseinrichtung 3 der Vorrichtung 1 ist unterhalb der Platine 2 angeordnet und weist zwei Kontaktstifte 11a und 11b auf, mit welchen durch die Leiterbahnen 10 gebildete Kontaktstellen 12 der Platine 2 kontaktierbar sind. In einem durchsichtig dargestellten Gehäuse 13 des elektromechanischen Schalters 6 ist zwischen den Kontakten 7a und 7b ein elektrischer Widerstand 14 und zwischen den Kontakten 7b und 7c ein elektrischer Widerstand 15 angeordnet.

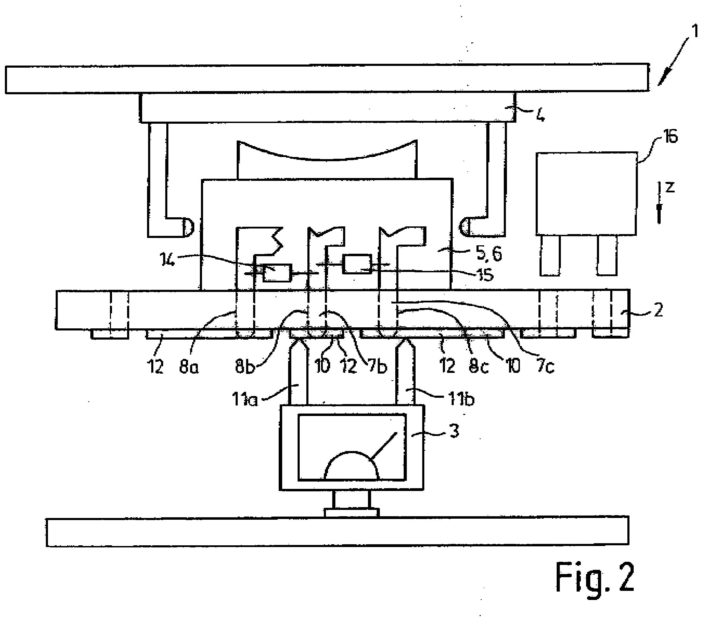

In der Figur 2 hat der Greifer 4 das Bauelement 5 bzw. den elektromechanischen Schalter 6 in eine Pfeilrichtung z in die Bohrungen 8a bis 8c der Platine 2 eingeschoben und den Schalter 6 losgelassen. Durch die Widerstandsmesseinrichtung 3 wird nun an zwei der Kontaktstellen 12 der Platine 2, welche mit den Kontakten 7b und 7c des Schalters 6 in Verbindung stehen, eine Widerstandsmessung durchgeführt. Hierzu wird die Widerstandsmesseinrichtung 3 mit ihren Kontaktstiften 11a und 11b gegen die entsprechenden Leiterbahnen 10 der Platine 2 gefahren. Sofern die elektrischen Widerstände 14 und 15 des Schalters 6 in zwei aufeinander folgenden Messungen korrekt erfasst werden, wird von einer ordnungsgemäßen Bestückung der Platine 2 mit dem Schalter 6 ausgegangen. In der Figur 2 ist ergänzend noch ein weiteres Bauelement 16 dargestellt, welches auf die Platine 2 gesetzt wird, wenn die Widerstandmessung eine korrekte Positionierung des Schalters 6 bestätigt hat.

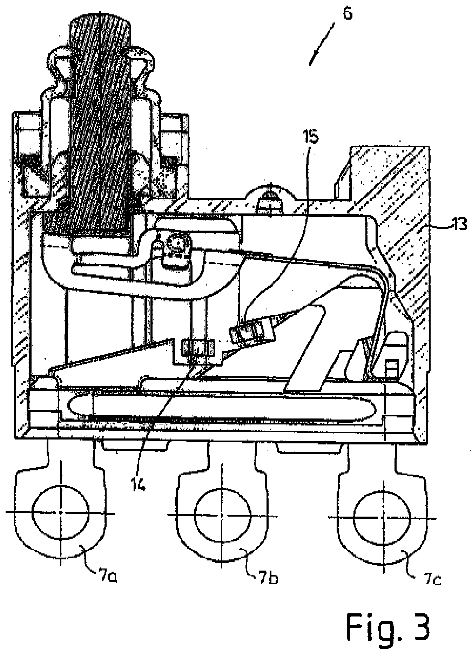

In der Figur 3 ist eine geschnittene Seitenansicht einer Ausführungsvariante eines elektromechanischen Schalters 6 dargestellt. Der Schalter 6 weist drei Kontakte 7a, 7b und 7c auf. In einem Gehäuse 13 bzw. Sockel des Schalters 6 sind wiederum Widerstände 14 bzw. 15 angeordnet, welche über die Kontakte 7a bis 7c bzw. über mit diesen verbundene, elektrisch leitfähige Bauteile messbar sind.

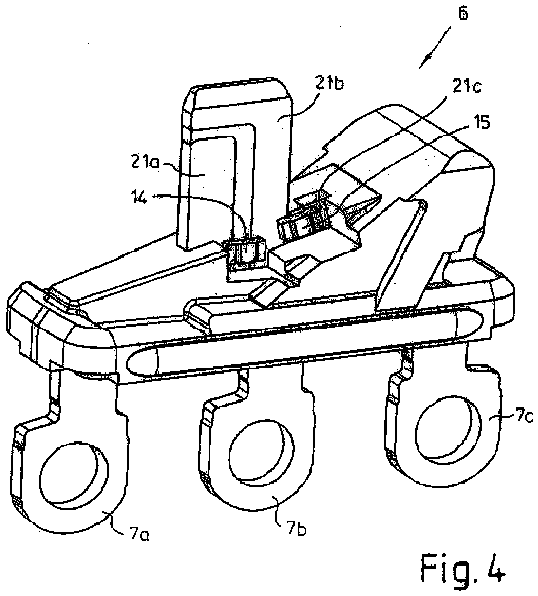

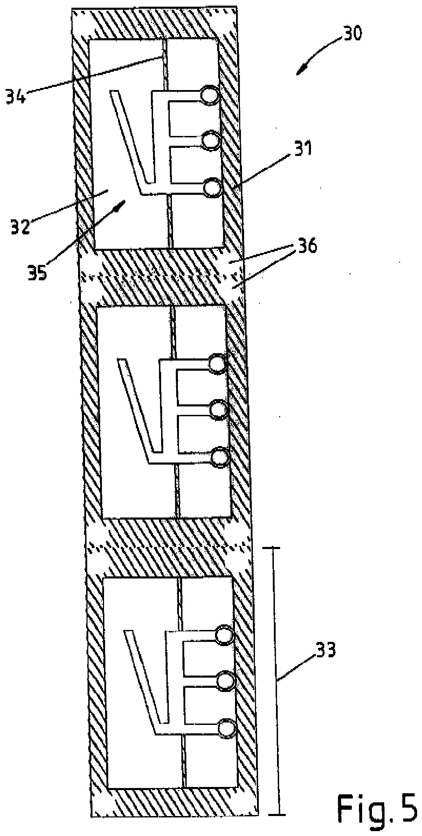

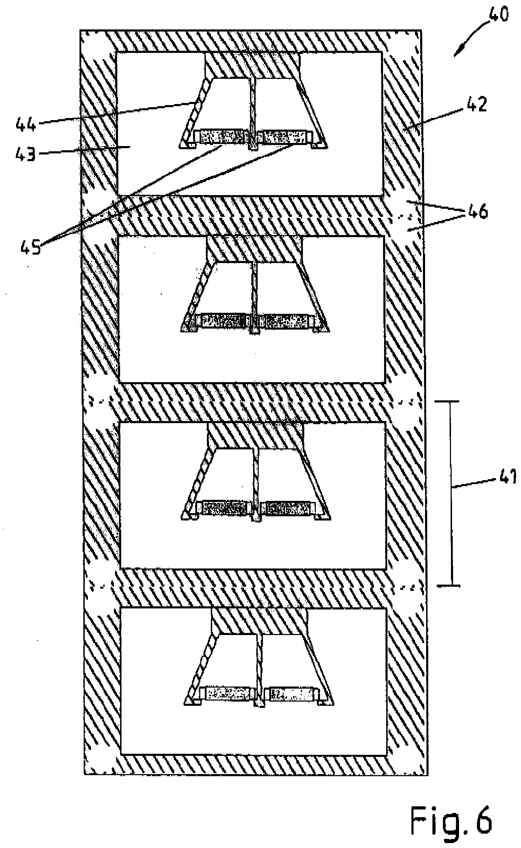

In der Figur 4 ist ein unterer Teil des in der Figur 5 gezeigten Schalters 6 in perspektivischer Ansicht dargestellt. Die Widerstände 14 und 15 sind im Schalter 6 auf Blechen 21a, 21b bzw. 21c beispielsweise mit Silberleitkleber aufgeklebt. Die Bleche 21a bis 21c stehen jeweils mit einem der Kontakte 7a, 7b, 7c in Verbindung. Somit sind die Kontakte 7a und 7b durch den Widerstand 14 und die Kontakte 7b und 7c durch den Widerstand 15 verbunden. Gemäß nicht dargestellten Ausführungsvarianten sind die Widerstände auf die Bleche aufgeschweißt oder aufgelötet. Die in den Figuren 5 und 6 gezeigten Widerständer 14 und 15 sind als sogenannte Miniaturwiderstände oder SMD-Widerstände ausgeführt. Hierdurch benötigen die Widerständen 14 und 15 im Schalter 6 nur minimale Bauräume.

Eine spätere negative Beeinträchtigung einer auf der Platine angeordneten elektronische Schaltung ist durch die Wahl von hochohmigen Widerständen praktisch ausgeschlossen. Die Widerstände in dem elektromechanischen Schalter übernehmen die Funktion von Messwiderständen. Eine Anordnung des oder der Messwiderstände erfolgt entsprechend dem Schaltertyp. Unter Schaltern sind im Sinne der Erfindung beispielsweise Wechsler bzw. Wechselschalter, Öffner, Schließer oder Mitte-0-Schalter zu verstehen.

In Figur 5 ist ein Ausschnitt aus einem erfindungsgemäßen Stanzgitter 30 mit in einem Gitterrahmen 31 befindliche Aufnahmebereich 32 dargestellt. Jedes Gittersegment 33, welches sich periodisch entlang des Stanzgitters 30 wiederholt, weist Halterungsfortsätze 34 zur Halterung eines Schalterrohlings 35 auf, welche einen in vorhergehenden Herstellungsschritten hergestellten Schalterrohling an einer definierten Position innerhalb des Stanzgitters 3C bereitstellen. In vorliegender Figur ist der Schalterrohling 35 nur schematisch dargestellt, ohne jedweilige auf dem Schalterrohling befindliche Anordnung an elektrischen Leiterbahnen oder Mechaniken. Das Stanzgitter 30 verfügt im Rahmen jedes Stanzgittersegments 33 über Positionierhilfe 36, welche sich in ähnlicher Periodizität zur Stanzgittersegmentwiederholung befinden.

Figur 6 zeigt ein weiteres erfindungsgemäßes Stanzgitter 40, vorliegend in einer zum Stanzgittern 30 um 90° gedrehten Anordnung der Stanzgittersegmente 41. Das Stanzgitter 40 weist ebenfalls einen Gitterrahmen 42 auf, Aufnahmebereiche 43 sowie Halterungen 44, an welchen vorliegend zwei Widerstände 45 angebracht sind. In einer nicht gezeigten Ausführung können an den Halterungen 44 auch vorgefertigte Widerstandsanordnungen angebracht sein, welche als Ganzes dem erfindungsgemäßen Verfahren zur Herstellung eines Bauelements zugeführt werden können. Ebenso wie das Stanzgitter 30 weist auch das Stanzgitter 40 Positionierhilfen 46 auf.

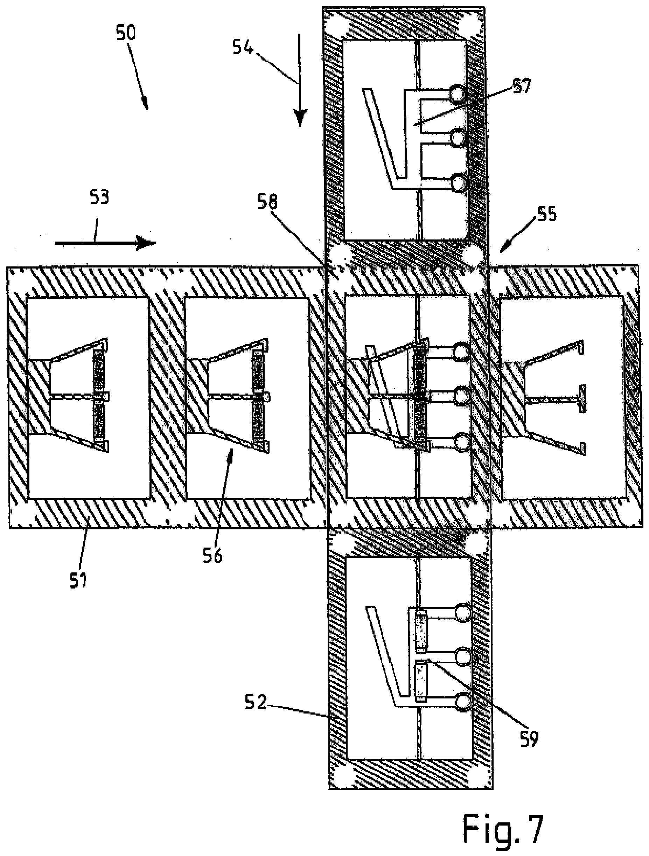

Figur 7 zeigt die erfindungsgemäße Anordnung 5C, zweier Stanzgitter 51 sowie 52, wobei das Stanzgitter 51 entlang der Arbeitsrichtung 53 nach jedem Arbeitsschritt um ein Stanzgittersegment fortbewegt wird, und das Stanzgitter 52 entlang der Arbeitsrichtung 54, rechtwinklig zur Arbeitsrichtung 53 pro Arbeitsschritt jeweils auch um ein Stanzgittersegment fortbewegt wird. Das Stanzgitter 51 weist vorliegend im Bereich vor einem Vereinigungsbereich bzw. Verarbeitungsbereich 55 gehalterte Widerstände 56 auf. Das Stanzgitter 52 weist in Analogie dazu gehalterte Schalterrohlinge 57 auf. Im Verarbeitungsbereich 55 wird unter Nutzung der Positionierhilfe 58 eine Positionierung der Widerstände 56 in einem zur Anbringung vorgesehenen Bereich am Schalterrohling 57 positioniert. Durch vorliegend nicht gezeigte Montagemittel, wie beispielsweise durch Lasermontagemittel, erfolgt in einem Arbeitsschritt sowohl die Abtrennung der Widerstände 56 aus dem Stanzgitter 51 als auch die Anbringung der Widerstände 56 auf dem Schalterrohling 57, welcher nach wie vor im Stanzgitter 52 gehalten wird. In einer nicht gezeigten Ausführung können die Widerstände 56 durch einen vorher gegangenen Arbeitsschritt mit ihrer Halterung in entsprechende Position gebracht werden sein, was dann notwendig ist, wenn die Montageposition im Verarbeitungsbereich 55 verlangt, dass die Widerstände 56 aus der lateralen Ebene des Stanzgitters 51 heraus gebraucht werden müssen, um die vorgegebene Position zur Anbringung im Bereich des Bauelements erreichen zu können. Entlang der Arbeitsrichtung 54 kann nach Verlassen des Vereinigungsbereich 55 der Schalter mit Widerständen 59 weiter verarbeitet werden.

Ein Problem bei der Herstellung derartiger Schalter stellt oftmals der Vorgang des Umspritzen des Bauelements beispielsweise mit Kunststoff dar, wenn auf dem Bauelement bereits in einem vorhergegangenen Arbeitsschritt Bauteile, insbesondere Widerstände 45 aufgebracht wurden. Die unterschiedlichen thermischen Ausdehnungskoeffizienten führen bei Umspritzen mit heißem Kunststoff dazu, dass Verbindungsstellen zwischen einem Schalterrohling 57 und den Widerständen 56 aufbrechen und so in ihrer Funktion beeinträchtigt sind. Wird beim Umspritzen nun ein entsprechender Bereich zur nachträglichen Anbringung von widerständen vorgesehen, beispielsweise eine Aussparung in der zu umspritzenden Form, so können mittels geeigneter Vorpositionierung der Widerstände 56 im Stanzgitter 51, welche in einem vorhergehenden Arbeitsschritt erfolgen kann, die Widerstände 56 in den Aussparungsbereich der Anspritzung eingesetzt werden, und sodann vorzugsweise mit einem Laser in einem Arbeitsschritt am Schalterrohling 57 befestigt werden, und gleichzeitig aus dem Stanzgitter 51 herausgetrennt werden.

Die Erfindung ist nicht auf dargestellte oder beschriebene Ausführungsbeispiele beschränkt. Sie umfasst vielmehr Weiterbildungen der Erfindung im Rahmen der Schuzzrechtsansprüche.

### Bezugszeichenliste:

- 1: Vorrichtung
- 2: Platine
- 3: Widerstandsmesseinrichtung
- 4: Greifer
- 5: Bauelement
- 6: elektromechanizcher Schalter
- 7a - 7c: Kontakt von 6
- 8a - 8c: Bohrung in 2
- 9: Träger von 2
- 10: Leiterbahn von 2
- 11a, 11b: Kontaktstift von 3
- 12: Kontaktstelle von 2
- 13: Gehäuse von 6
- 14: elektrischer Widerstand
- 15: elektrischer Widerstand
- 15a, 15b: Leiter von 15
- 16: weiteres Bauelement zur Anordnung auf 2
- 17: Tasche in 6
- 18: Innenraum von 17
- 19: Klammer zur Kontaktierung von 15
- 19a, 19b: Backe von 19
- 20: Klammer zur Kontaktierung von 15
- 20a, 20b: Backe von 20
- 21a - 21c: Blech verbunden mit 7a bzw. 7b bzw. 7c
- z: Pfeilrichtung
- 30: Stanzgitter längs
- 31: Gitterrahmen
- 32: Aufnahmebereich
- 33: Stanzgittersegment
- 34: Halterungsfortsätze
- 35: Schalterrohling
- 36: Positionshilfen (Rasterlöcher)
- 40: Stanzgitter quer
- 41: Stanzgittersegment
- 42: Gitterrahmen
- 43: Aufnahmebereich
- 44: Halterung
- 45: Widerstand
- 46: Pcsitionierhilfen
- 50: Anordnung
- 51: Stanzgitter "R"
- 52: Stanzgitter "SW"
- 53: Arbeitsrichtung
- 54: Arbeitsrichtung
- 55: Vereinigungsbereich
- 56: Widerstände
- 57: Schalterrchlinge
- 58: Positionierhilfe
- 59: Schalter mit Widerständen

## Patentansprüche

1. Verfahren zur Herstellung eines elektromechanischen Schalters (6) mittels Stanzgitter (30, 40), wobei der Schalter Kontakte zur Kontaktierung einer Platine (2) aufweist, **dadurch gekennzeichnet, dass**
mindestens ein Widerstand (45) zwischen den Kontakten (7a, 7b und 7c) als Messwiderstand angebracht wird, wobei in einem ersten Stanzgitter (30) Schalterrohlinge (35) und in einem zweiten Stanzgitter (40) elektrische Widerstände (45) als Messwiderstand angeordnet werden und wobei die Stanzgitter durch Positionierhilfen (36, 46, 58) relativ zueinander positioniert und sodann die Anbringung des mindestens einen Widerstandes (45) als auch die Abtrennung vom Stanzgitter des Widerstandes vorgenommen wird.

2. Verfahren nach Anspruch 1 **dadurch gekennzeichnet, dass** die Positionierhilfen (36, 46, 58) als Rasterlöcher in den Stanzgittern vorgesehen werden.

3. Verfahren nach Anspruch 1 oder 2, **dadurch gekennzeichnet, dass** die Anbringung des mindestens einen Widerstands (45) auf der Kontaktanordnung des Schalters (57) im Arbeitsschritt der Abtrennung von seinem Stanzgitter erfolgt.

4. Verfahren nach Anspruch 1, 2 oder 3, **dadurch gekennzeichnet, dass** die Anbringung des mindestens einen Widerstands (45) sowie dessen Abtrennung aus seinem Stanzgitter auf der Kontaktanordnung des Schalters (57) mittels Laserstrahlung erfolgt.

5. Verfahren nach einem der Ansprüche 1 bis 4, **dadurch gekennzeichnet, dass** die Stanzgitter (30, 40) entlang jeweils einer Vorschubrichtung (53, 54) geführt werden, wobei die Vorschubrichtungen parallel oder sich kreuzend, insbesondere rechtwinklig verlaufen.

6. Verfahren nach einem der Ansprüche 1 bis 5, **dadurch gekennzeichnet, dass** eine Vorpositionierung der im jeweiligen Stanzgitter (30, 40) gehaltenen Bestandteile (35, 45), insbesondere eine Vorpositionierung des mindestens einen Widerstands (45), in einem vorhergehenden Arbeitsschritt erfolgt.

7. Verfahren nach einem der Ansprüche 1 bis 6, wobei in einem ersten Stanzgitter (51) entlang einer ersten Vorschubrichtung (53) mehrere Widerstände (45) in einem vorgesehenen Abstand pro Stanzgittersegment (41) angeordnet sind, und wobei in einem zweiten Stanzgitter (52) entlang einer zweiten Vorschubrichtung (54) eine gegebenenfalls mit einem Sockel umspritzte Kontaktanordnung für einen Schalter (57) pro Stanzgittersegment (33) angeordnet ist, **dadurch gekennzeichnet, dass** die Stanzgittersegmente (33, 41) entlang ihrer Vorschubrichtungen (53, 54) in überdeckende Positionierung (55), vorzugsweise mit einer Positionierungshilfe (58), insbesondere einem Raster, gebracht werden, und in einem daraus entstehenden Vereinigungsbereich (55) die Widerstände (45) in einem Arbeitsschritt auf dem Schalter (57) im zur Anbringung vorgesehenen Bereich angebracht werden.

## Claims

1. Method for producing an electromechanical switch (6) by means of a leadframe (30, 40), wherein the switch comprises contacts for contacting a printed circuit board (2),
**characterized in that**
at least one resistance (45) is arranged between the contacts (7a, 7b, and 7c) as a measuring resistance, wherein switch blanks (35) are arranged in a first leadframe (30), while electrical resistances (45) are arranged as measuring resistances in a second leadframe (40), wherein the leadframes are arranged relative to one another by positioning aids (36, 46, 58), so that the mounting of the at least one resistance (45) as well as separation of the resistance from the leadframe is then carried out.

2. Method according to claim 1,
**characterized in that**
the positioning aids (36, 46, 58) are provided as raster holes in the leadframes.

3. Method according to claim 1 or 2,
**characterized in that**
the at least one resistance (45) is mounted on the contact arrangement of the switch (57) in the work step of the separation from its leadframe.

4. Method according to claim 1, 2 or 3,
**characterized in that** the mounting of the at least one resistance (45) as well as its separation from its leadframe are effected on the contact arrangement of the switch (57) by means of laser radiation.

5. Method according to one of the claims 1 to 4,
**characterized in that**
the leadframes (30, 40) are respectively guided in a feed direction (53, 54), wherein the feed directions extend in parallel or intersect, in particular, at right angles.

6. Method according to one of the claims 1 to 5,
**characterized in that**
a pre-positioning of the components (35, 45) held in the respective leadframe (30, 40), in particular pre-positioning of the at least one resistance (45), takes place in a preceding working step.

7. Method according to one of the claims 1 to 6, wherein a plurality of resistances (45) is arranged in a first leadframe (51) along a first feed direction (53) at a given distance per leadframe segment (41), and wherein an overmolded contact arrangement possibly with a base for a switch (57) per leadframe segment (33) is arranged in a second leadframe segment (52), along a second feed direction (54)
**characterized in that**
the leadframe segments (33, 41) are arranged along their feed directions (53, 54) in overlapping positioning (55), preferably with a positioning aid (58), in particular a raster, wherein the resistances (45) are mounted on the switch (57) in the area provided for mounting in a joining region (55) which results therefrom.

## Revendications

1. Procédé de fabrication d'un interrupteur électromécanique (6) au moyen d'une grille estampée (30, 40), l'interrupteur comprenant des contacts pour la mise en contact d'une platine (2), **caractérisé en ce que**
au moins une résistance (45) entre les contacts (7a, 7b et 7c) étant montée en tant que résistance de mesure, moyennant quoi, dans une première grille estampée (30), sont disposés des ébauches d'interrupteurs (35) et, dans une deuxième grille estampée (40), sont disposées des résistances électriques (45) en tant que résistances de mesure et les grilles estampées étant positionnées l'un par rapport à l'autre grâce à des aides au positionnement (36, 46, 58) et le montage de l'au moins une résistance (45) ainsi que la séparation de la grille estampée de la résistance sont ensuite effectués.

2. Procédé selon la revendication 1, **caractérisé en ce que** les aides au positionnement (36, 46, 58) sont prévues comme des perforations régulières dans les grilles estampées.

3. Procédé selon la revendication 1 ou 2, **caractérisé en ce que** le montage de l'au moins une résistance (45) a lieu sur le dispositif de contact de l'interrupteur (57) dans l'étape de séparation de sa grille estampée.

4. Procédé selon la revendication 1, 2 ou 3, **caractérisé en ce que** le montage de l'au moins une résistance (45) ainsi que sa séparation de sa grille estampée ont lieu sur le dispositif de contact de l'interrupteur (57) au moyen d'un rayon laser.

5. Procédé selon l'une des revendications 1 à 4, **caractérisé en ce que** les grilles estampées (30, 40) sont guidées le long d'une direction d'avance (53, 54), les directions d'avance s'étendant parallèlement ou se croisant, plus particulièrement de manière perpendiculaire.

6. Procédé selon l'une des revendications 1 à 5, **caractérisé en ce qu'**un pré-positionnement des composants (35, 45) maintenus dans la grille estampée (30, 40) correspondante, plus particulièrement un pré-positionnement de l'au moins une résistance (45), a lieu dans une étape précédente.

7. Procédé selon l'une des revendications 1 à 6, moyennant quoi, dans une première grille estampée (51), le long d'une première direction d'avance (53) sont disposées plusieurs résistances (45) à une distance prédéterminée sur chaque segment de grille estampée (41) et, dans une deuxième grille estampée (52), le long d'une deuxième direction d'avance (54), est dispositif un dispositif de contact pour un interrupteur (57), le cas échéant surmoulé avec un socle, sur chaque segment de grille estampée (33), **caractérisé en ce que** les segments de grille estampée (33, 41) sont amenés le long de leurs directions d'avance (53, 54), vers un positionnement superposé (55), de préférence avec une aide au positionnement (58), plus particulièrement une trame, et dans une zone d'unification (55) qui en résulte, les résistances (45) sont montées, lors d'une étape de travail, dans la zone prévue à cet effet sur l'interrupteur (57).
